Europäisches Patentamt

European Patent Office

Office européen des brevets

(11) Veröffentlichungsnummer: **0 421 127 A1**

# (12) EUROPÄISCHE PATENTANMELDUNG

(21) Anmeldenummer: 90116722.1

(22) Anmeldetag: 31.08.90

(51) Int. Cl.5: **C25D 17/00, C25D 5/08**

(30) Priorität: 07.09.89 DE 3929728

(43) Veröffentlichungstag der Anmeldung:
**10.04.91 Patentblatt 91/15**

(84) Benannte Vertragsstaaten:
**AT BE CH DE ES FR GB GR IT LI NL SE**

(71) Anmelder: **Krämer, Werner M.**
**An der Altenbach 40**
**W-6706 Wachenheim(DE)**

Anmelder: **Schiffler, Willi**
**Am Schlösschen 12**
**W-6683 Spiesen-Elversberg(DE)**

(72) Erfinder: **Krämer, Werner M.**
**An der Altenbach 40**
**W-6706 Wachenheim(DE)**
Erfinder: **Schiffler, Willi**
**Am Schlösschen 12**
**W-6683 Spiesen-Elversberg(DE)**

(74) Vertreter: **Bernhardt, Winfrid, Dr.-Ing.**
**Kobenhüttenweg 43**
**W-6600 Saarbrücken(DE)**

(54) **Anlage zur Herstellung von Leiterplatten und Verfahren zum Betreiben der Anlage.**

(57) In einer Anlage zur Herstellung von Leiterplatten werden Trägerplatten zur Herstellung der Leiter auf ihrer Oberfläche in einer waagerechten Fertigungslinie nacheinander durch Behandlungsmedien enthaltende Becken (3) transportiert.

Die Becken (3) sind mit ihrer Höhe einer senkrecht hängenden Anordnung der Trägerplatten angepaßt. Die Trägerplatten werden durch in gegenüberliegenden Seitenwänden der Becken (3) angeordnete, mit Dichtungen versehene Schlitze (5) hindurchgeführt. Um die an den Dichtungen unvermeidlich auslaufende Flüssigkeit zu sammeln und in den Becken (3) zu ersetzen, stehen die Becken (3) in Auffangbecken (12), aus denen über entsprechende Leitungsverbindungen (19,21) das Behandlungsmedium ständig in die Becken (3) zurückgepumpt wird, und zwar derart, daß das Behandlungsmedium ständig am oberen Beckenrand (15) überläuft.

Weitere Einrichtungen ermöglichen eine elektrische Kontaktierung der Leiterplatten in galvanischen Bädern.

Fig. 6

# ANLAGE ZUR HERSTELLUNG VON LEITERPLATTEN UND VERFAHREN ZUM BETREIBEN DER ANLAGE

Die Erfindung betrifft eine Anlage zur Herstellung von Leiterplatten, bei der Trägerplatten zur Herstellung der Leiter auf ihrer Oberfläche in einer waagerechten Fertigungslinie nacheinander durch Behandlungsmedien enthaltende Becken durch in gegenüberliegenden Seitenwänden der Becken angeordnete Dichtungen hindurch zu transportieren sind.

Eine solche Anlage ist in der Form bekannt, daß die Trägerplatten auf Rollen liegend durch flache Becken hindurch transportiert werden. Weitgehend in Gebrauch sind Anlagen mit Tauchbecken, in die die Leiterplatten von oben her hängend eingetaucht werden.

In einer dritten Art von Anlagen wird nach dem sogenannten Schwallverfahren gearbeitet. Die Trägerplatten werden mit den Behandlungsmedien bespült in aneinandergereihten Gehäusen, die sie unter Durchtritt durch Schlitze in den Gehäusewänden in einer Fertigungslinie durchlaufen.

Die erstere Herstellung ist rationell und führt zu einer gleichmäßigen Beaufschlagung der Trägerplatten mit den Behandlungsmedien jeweils auf einer Seite, jedoch an den beiden Seiten unterschiedlich. Die zweite Verfahrensweise hat als Vorteil eine gleiche und gleichmäßige Beaufschlagung der beiden Seiten; sie ist jedoch unrationell. Das Schwallverfahren ist rationell und beaufschlagt beide Seiten gleich, aber nicht ganz gleichmäßig.

Der Erfindung liegt die Aufgabe zugrunde, eine Lösung zu finden, die rationell ist und bei der beide Seiten gleich und gleichmäßig beaufschlagt werden.

Die erfindungsgemäße Anlage, die diese Forderungen erfüllt, hat mit der genannten ersteren Technik die eingangs angegebenen Merkmale gemeinsam und unterscheidet sich dadurch, daß die Becken mit ihrer Höhe einer senkrecht hängenden Anordnung der Trägerplatten angepaßt und die genannten Dichtungen senkrecht angeordnet sind, daß die Becken in Auffangbecken angeordnet und mit Einrichtungen zum Umpumpen der Behandlungsmedien aus den Auffangbecken in die Becken versehen sind und daß über den Becken eine Transporteinrichtung für hängenden Transport der Trägerplatten angeordnet ist.

In der Erfindung liegt u.a. die Erkenntnis, daß die bei mindestens 30 und bis zu 50 cm abzudichtender Flüssigkeitshöhe nicht unerheblichen Ausflüsse an den Dichtungen bei systematischem Umpumpen in die Becken einen Nachteil darstellen, den die zugleich erzielten Vorteile im Herstellungsgang und der erreichten Qualität überwiegen.

Besonders vorteilhaft ist in dieser Hinsicht die Ausgestaltung der Erfindung, daß die Einrichtungen zum Umpumpen ständig mit Überlauf der Becken, vorzugweise am oberen Beckenrand, arbeiten.

Auf diese Weise wird mit geringem Aufwand immer gleiche Füllhöhe, d.h. gleicher Druck gewährleistet.

Vorzugsweise münden unterhalb der Bahn der Trägerplatten auf der Querschnittsmitte der Becken Umpumpleitungen in Bahnrichtung ein, so daß die eingepumpte Flüssigkeit gleichmäßig auf die beiden Seiten der Trägerplatten gelangt, langsam hochsteigt und gleichmäßig auf den beiden Seiten der Trägerplatten am Beckenrand überfließt.

Der Füllstand in den Auffangbecken wird zweckmäßigerweise unter der Bahn der Trägerplatten gehalten, damit dort nicht gleichfalls abgedichtet werden muß.

Trotzdem ist es zweckmäßig, wenn die Auffangbecken mindestens die Höhe der Becken haben und an ihren Durchtrittsstellen für die Trägerplatten gleichfalls mit Dichtungen versehen sind.

Dann werden auch an den Dichtungen der Becken eventuell austretende Spritzstrahlen vollständig und sicher abgefangen. Im übrigen kann dann eine Abdeckung über Becken und Auffangbecken gebracht werden, die die oft von den Behandlungsmedien aufsteigenden gesundheitsschädigenden Dämpfe zurückhält. Auf diese Weise kann das bisher regelmäßig sehr belastete Raumklima in den betreffenden Herstellungsstätten erheblich verbessert werden.

Als Dichtungen werden zweckmäßigerweise Bürstendichtungen oder Streifenbürstendichtungen eingesetzt.

Weiter erlaubt es die erfindungsgemäße Anlage, mit einer entsprechenden Beschickungseinrichtung die Trägerplatten mit minimalem Abstand voneinander der Transporteinrichtung aufzugeben. Damit vergleichmäßigt sich das elektrische Feld, und die bisher sehr störenden Ungleichmäßigkeiten des Materialauftrags werden zumindest gemildert.

Nach einer weiteren besonders vorteilhaften Weiterbildung der Erfindung weist für galvanische Behandlung die Transporteinrichtung mindestens streckenweise für die, in die Behandlungsmedien voll eintauchenden, Trägerplatten elektrisch leitende Halter, vorzugsweise Klammern, auf, die oberhalb der Becken mit Schleifkontakten versehen sind, für die über mindestens einem der Becken mindestens eine negativ gepolte Kontaktschiene angeordnet ist. Dies ist eine besonders zweckmäßige Lösung des Problems, nur an bestimmten Becken der Fertigungslinie die Leiterplatten unter eine Spannung zu setzen und dies in einer zweckmäßigen, den Verfahrensgang nicht störenden Weise.

Um die unvermeidliche galvanische Beschichtung der Halter wieder abzutragen, kann die Transporteinrichtung, die die Halter ohnehin an endlos umlaufenden Transportbändern aufweisen wird, unter dem Rücktrum Reinigungsbäder für die Klammern und über den Reinigungsbädern eine positiv gepolte Kontaktschiene für die Schleifkontakte aufweisen.

Zweckmäßigerweise sind die Halter aus jeweils zwei Fingern zusammengesetzte Klammern und die beiden Finger sitzen an zwei verschiedenen, synchron endlos umlaufenden Transportbändern, deren in Transportrichtung laufende Trume aneinanderliegen.

Da in der Regel beide Seiten der Trägerplatten mit der Spannung beaufschlagt werden sollen, werden dann beiden Fingern Schleifkontakte und Kontaktschienen zugeordnet sein.

Die Schleifkontakte und die Kontaktschienen sind zweckmäßigerweise oberhalb der Transportbänder angeordnet, d.h. die Schleifkontakte sind nach oben aus den Haltern herausgeführt.

Dort stören die Kontaktierungseinrichtungen andere Belange nicht.

Schließlich eröffnet die Erfindung die vorteilhafte Möglichkeit, die Anlage mit mindestens einer Einrichtung zur Dickenmeßung der Platten mittels Meßsonden zu versehen und den Betrieb der Anlage mindestens teilweise ausgehend von der Dickenmeßung zu steuern.

Die Zeichnung gibt ein Ausführungsbeispiel der Erfindung wieder.

Fig. 1 zeigt eine Anlage zur Herstellung von Leiterplatten in Draufsicht,

Fig. 2 zeigt schematisch eine Einzelheit in Draufsicht,

Fig. 3 zeigt die Einzelheit in Ansicht gemäß Fig. 5 von links,

Fig. 4 zeigt einen kleinen Auschnitt aus Fig. 1 in waagerechtem Schnitt,

Fig. 5 zeigt den Ausschnitt in einem senkrechten Schnitt nach Linie V-V in Fig. 5,

Fig. 6 zeigt den Ausschnitt in einem senkrechten Schnitt nach Linie VI-VI in Fig. 4,

Fig. 7 zeigt einen etwa Fig. 6 entsprechenden Schnitt mit anderen Einzelheiten.

In einer geraden Fertigungslinie 1 ist eine Vielzahl von Behandlungsbädern 2 aneinandergereiht. Durch diese Behandlungsbäder werden Trägerplatten, aus denen durch Herstellung von Leitern an ihrer Oberfläche Leiterplatten hergestellt werden sollen, hängend hindurchgeführt. Dafür sind die die Behandlungsmedien enthaltenden Becken an ihren Seitenwänden geschlitzt und mit Dichtungen versehen.

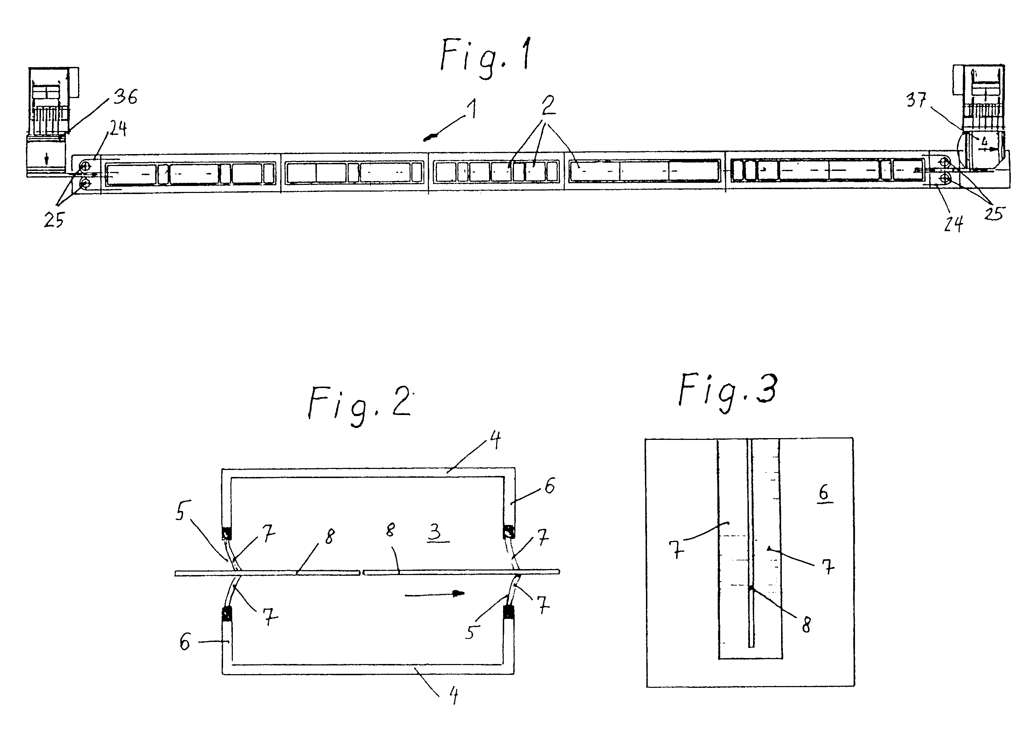

Fig. 2 und 3, die dies schematisch zeigen, lassen ein Becken 3 mit Längswänden 4 und einander gegenüber mit Schlitzen 5 versehene Querwände 6 erkennen. Die Schlitze 5 sind abgedichtet mittels Streifenbürstendichtungen, deren beide Flügel 7 im Betriebszustand an den Trägerplatten 8 und im Ruhezustand aneinander dichtend anliegen.

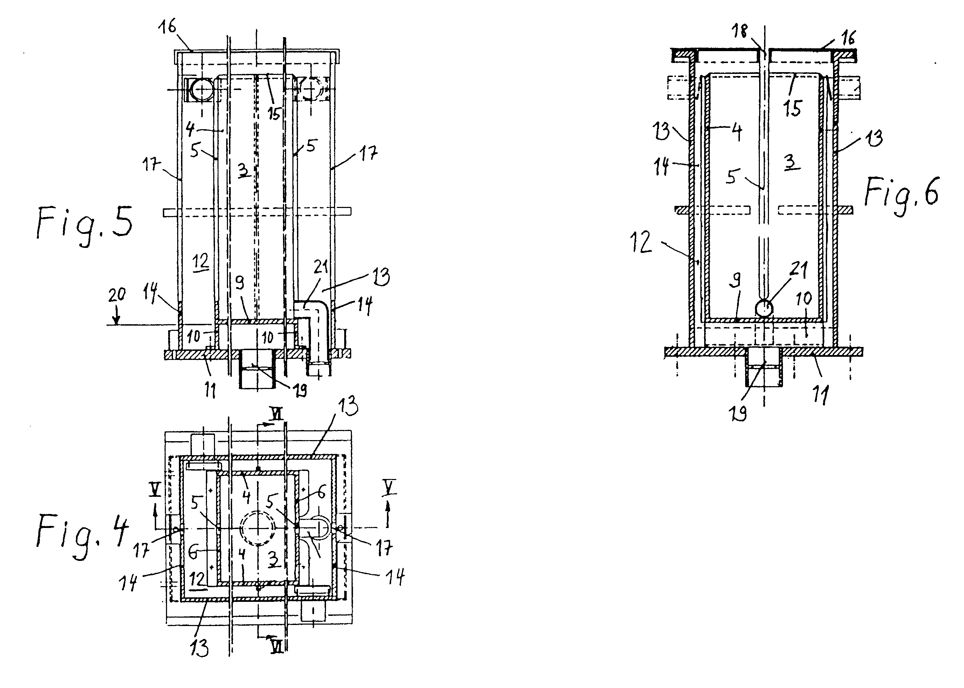

Konkreter und maßstäblicher ist das Becken 3 wiedergegeben in Fig. 4 bis 6, jedoch ohne die Streifenbürstendichtungen an den Schlitzen 5.

Wie Fig. 5 und 6 erkennen lassen, steht das Becken 3 mit durch Fortsetzungen seiner Querwände 6 über den Beckenboden 9 hinaus nach unten gebildeten Füßen 10 auf dem Boden 11 eines Auffangbeckens 12. Das Auffangbecken 12 umgibt das Becken 3 mit Längswänden 13 und Querwänden 14 und ragt über dessen Beckenrand 15 ein Stück nach oben hinaus, so daß es mit einem Deckel 16 abgedeckt sein kann. Auch die Querwände 14 weisen, in Flucht mit den Schlitzen 5, Schlitze 17 auf, und der Deckel 16 ist mit einem über den Schlitzen 5 und 17 verlaufenden Schlitz 18 versehen. An den Schlitzen 17 befinden sich wiederum nicht gezeichnete Streifenbürstendichtungen.

Eine in der Zeichnung nicht erscheinende Pumpe saugt durch einen im Boden 11 des Auffangbeckens 12 angeordneten Abfluß 19 ständig ein das Auffangbecken 12 bis zu dem angegebenen Niveau 20 und das Becken 3 vollständig füllendes Behandlungsmedium an und pumpt es durch die Zuleitung 21 in das Becken 3, das damit ständig überläuft. Die Mündung der Zuleitung 21 liegt in der einen Querwand 6 unter dem Schlitz 5 und ist waagerecht axial in das Becken 3 gerichtet. Die einströmende Flüssigkeit verteilt sich so gleichmäßig auf die beiden Seiten der, in Fig. 4 bis 6 nicht gezeichneten, Trägerplatte(n).

Außer als Überlauf über den Beckenrand 15 kommt Behandlungsmedium an den Streifenbürstendichtungen der Schlitze 5 heraus und wird im Auffangbecken 12 gesammelt.

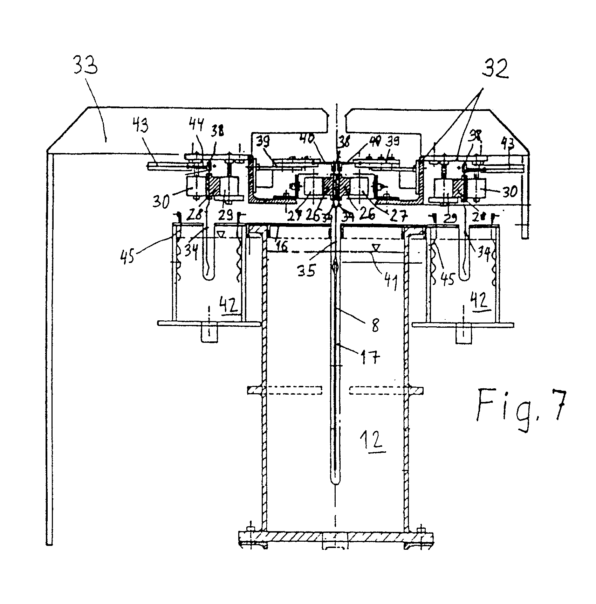

Eine Transporteinrichtung 22, an der die Trägerplatten hängen und die sie durch die Behandlungsbäder 2 hindurchführt, ist in Fig. 1 nur angedeutet und in Fig. 7 genauer dargestellt:

Zwei am Anfang und am Ende der Fertigungslinie 1 über Umlenkrollen 23 gelegte Transportbänder 24 liegen mit ihren in Förderrichtung laufenden Trumen 26 in der senkrechten Längsmittelebene der Fertigungslinie aneinander. Sie sind auf ihrer Länge vielfach durch Rollen gehalten. Die Trume 26 werden durch in engen Abständen aufeinanderfolgende Rollen 27 aneinander gedrückt. Die anderen Trume 28 werden von Halterollen 29 getragen und an diesen durch Sicherungsrollen 30 gehalten. Das ganze ist getragen von einer Rahmenkonstruktion 22 und von einer Haube 33 überdeckt.

An den Transportbändern 24 sitzen aus federnden Blechstreifen bestehende Finger 34, die sich infolge entsprechender Synchronisierung der Transportbänder 24 an den Trumen 26 zu Klammern 35 zusammenlegen. An den Klammern 35 werden am Anfang der Fertigungslinie 1 die Trägerplatten 8 mit einem minimalen Abstand aneinderschließend aufgehängt durch eine Beschickungseinrichtung 36. Eine Aufnahmeeinrichtung 37 übernimmt am Ende der Fertigungslinie 1 die fertigen Leiterplatten von den Klammern 35.

Die erwähnten federnden Blechstreifen der Finger 34 erstrecken sich durch die Breite der Transportbänder 24 hindurch, ragen oben heraus und tragen hier Schleifkontakte 38. Über galvanischen Behandlungsbädern sind Kontaktschienen 39 mit Streifenbürsten 40 angeordnet, an denen die Schleifkontakte 38 unter Berührung entlanglaufen. So werden durch die beiden Finger 34 die beiden kupferbeschichteten Seiten der Trägerplatten 8 auf das erforderliche Potential gebracht.

Da die Klammern mit eintauchen, siehe das in Fig. 7 eingezeichnete Niveau 41, werden die Finger 34 gleichfalls galvanisch beschichtet. Um diese Beschichtung abzutragen, werden die Finger 34 an den anderen, rücklaufenden Trumen 28 durch Reinigungsbäder 42 geleitet und hier umgekehrt gepolt. Dazu dienen Kontaktschienen 43 mit Streifenbürsten 44 sowie Tauchelektroden 45 in der Flüssigkeit.

**Ansprüche**

1. Anlage zur Herstellung von Leiterplatten, bei der Trägerplatten (8) zur Herstellung der Leiter auf ihrer Oberfläche in einer waagerechten Fertigungslinie (1) nacheinander durch Behandlungsmedien enthaltende Becken (3) durch in gegenüberliegenden Seitenwänden (6) der Becken (3) angeordnete Dichtungen (7) hindurch zu transportieren sind, dadurch gekennzeichnet, daß die Becken (3) mit ihrer Höhe einer senkrecht hängenden Anordnung der Trägerplatten (8) angepaßt und die genannten Dichtungen (7) senkrecht angeordnet sind, daß die Becken (3) in Auffangbekken (12) angeordnet und mit Einrichtungen (19,21) zum Umpumpen der Behandlungsmedien aus den Auffangbecken (12) in die Becken (3) versehen sind und daß über den Becken (3) eine Transporteinrichtung (24) für hängenden Transport der Trägerplatten (8) angeordnet ist.

2. Anlage nach Anspruch 1, dadurch gekennzeichnet, daß die Einrichtungen (19,21) zum Umpumpen ständig mit Überlauf der Becken (3), vorzugsweise am oberen Beckenrand (15), arbeitende Einrichtungen sind.

3. Anlage nach Anspruch 1 oder 2, gekennzeichnet durch unterhalb der Bahn der Trägerplatten (8) auf der Querschnittsmitte in Bahnrichtung in die Becken (3) mündende Umpumpleitungen (21).

4. Anlage nach einem der Ansprüche 1 bis 3, dadurch gekennzeichnet, daß der Füllstand (20) in den Auffangbecken (12) unter der Bahn der Trägerplatten (8) liegt.

5. Anlage nach einem der Ansprüche 1 bis 4, dadurch gekennzeichnet, daß die Auffangbecken (12) mindestens die Höhe der Becken (3) haben und vorzugsweise Abdeckungen (16) darüber angeordnet sind.

6. Anlage nach einem der Ansprüche 1 bis 5, dadurch gekennzeichnet, daß die Auffangbecken (12) an ihren Durchtrittsstellen (17) für die Trägerplatten (8) gleichfalls mit Dichtungen versehen ist.

7. Anlage nach einem der Ansprüche 1 bis 6, dadurch gekennzeichnet, daß die Dichtungen Bürstendichtungen oder Streifenbürstendichtungen (7) sind.

8. Anlage nach einem der Ansprüche 1 bis 7, gekennzeichnet durch eine die Trägerplatten (8) mit minimalem Abstand voneinander der Transporteinrichtung (24) aufgebende Beschickungseinrichtung (36).

9. Anlage nach einem der Ansprüche 1 bis 8, dadurch gekennzeichnet, daß für galvanische Behandlung die Transporteinrichtung (24) mindestens streckenweise für die, in die Behandlungsmedien voll eintauchenden, Trägerplatten (8) elektrisch leitende Halter (34,35), vorzugsweise Klammern (35), aufweist, die oberhalb der Becken (3) mit Schleifkontakten (38) versehen sind, für die über mindestens einem der Becken (3) mindestens eine negativ gepolte Kontaktschiene (39,40) angeordnet ist.

10. Anlage nach Anspruch 9, dadurch gekennzeichnet, daß die Transporteinrichtung (24) die Halter (34,35) an endlos umlaufenden Transportbändern (24) aufweist und unter dem Rücktrum (28) Reinigungsbäder (42) für die Klammern (34) und über den Reinigungsbädern eine positiv gepolte Kontaktschiene (43,44) für die Schleifkontakte (38) aufweist.

11. Anlage nach Anspruch 9 oder 10, dadurch gekennzeichnet, daß die Halter (34,35) aus jeweils zwei Fingern (34) zusammengesetzte Klammern (35) sind und die beiden Finger (34) an zwei verschiedenen, synchron endlos umlaufenden Transportbändern (24) sitzen, deren in Transportrichtung laufende Trume (26) aneinanderliegen.

12. Anlage nach Anspruch 11, dadurch gekennzeichnet, daß beiden Fingern (34) Schleifkontakte (38) und Kontaktschienen (39,40) zugeordnet sind.

13. Anlage nach einem der Ansprüche 10 bis 12, dadurch gekennzeichnet,

daß die Schleifkontakte (38) und die Kontaktschiene(n) (39,40) oberhalb der Transportbänder (24) angeordnet sind.

14. Anlage nach einem der Ansprüche 1 bis 12, dadurch gekennzeichnet, daß sie mit mindestens einer Einrichtung zur Dickenmessung der Platten (8) mittels Meßsonden versehen ist.

15. Verfahren zum Betreiben einer Anlage nach Anspruch 14, dadurch gekennzeichnet, daß die Anlage mindestens teilweise ausgehend von der Dickenmessung gesteuert wird.

EP 0 421 127 A1

# Fig. 1

# Fig. 2

# Fig. 3

Fig.6

Fig.5

Fig.4

EP 0 421 127 A1

Fig. 7

8

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | US-A-4 372 825 (EIDSCHUN)<br>* Figur 1 *<br>– – – | 1-4,6,8,9 | C 25 D 17/00<br>C 25 D 5/08 |
| X | US-A-4 401 522 (BUSCHOW)<br>* Figuren 1,3,5,7,9 *<br>– – – – – | 1-9 | |
| | | | **RECHERCHIERTE SACHGEBIETE (Int. Cl.5)**<br><br>C 25 D<br>H 05 K |

Der vorliegende Recherchenbericht wurde für alle Patentansprüche erstellt

| Recherchenort | Abschlußdatum der Recherche | Prüfer |
|---|---|---|
| Den Haag | 20 Dezember 90 | NGUYEN THE NGHIEP |